# DEMANDE DE BREVET EUROPEEN

(11) **EP 1 677 364 A1**
(43) Date de publication de la demande: **05.07.2006**
(21) Numéro de dépôt: 05113047.4
(22) Date de dépôt: 28.12.2005
(51) Int. Cl.: H01L 31/105, H01L 31/09, H01L 27/146

(54) **Capteur de lumière situé au-dessus d'un circuit intégré**

(30) Priorité: 30.12.2004 FR 0453264
(71) Demandeur: ST MICROELECTRONICS S.A., 92120 Montrouge (FR)
(72) Inventeur: Thomas, Danielle, 38330, SAINT ISMIER (FR); Rivoire, Maurice, 38240, MEYLAN (FR)
(74) Mandataire: de Beaumont, Michel

(57) **Abrégé**

L'invention concerne un capteur de lumière situé au-dessus d'un circuit intégré comportant une électrode inférieure (21), une couche de silicium amorphe fortement dopé (23) d'un premier type de conductivité, et une couche de silicium amorphe faiblement dopé (22) d'un second type de conductivité. La couche de silicium amorphe faiblement dopée (22) repose sur une surface plane au moins au-dessus et au voisinage de l'électrode inférieure.

## Description

La présente invention concerne le domaine de la microélectronique et plus précisément celui des capteurs de lumière associés à un circuit intégré.

Les capteurs de lumière sont des dispositifs qui permettent de transformer une information lumineuse en signal électrique. On peut répartir plusieurs millions de ces capteurs sur une surface afin de créer une image électrique comportant des millions de points. Usuellement, un capteur est constitué d'une photodiode et d'un circuit MOS permettant de collecter et de traiter le signal électrique issu de la photodiode.

La photodiode peut être réalisée dans du silicium monocristallin. Dans ce cas, le circuit MOS et la photodiode coexistent dans un substrat en silicium monocristallin et sont situés sensiblement dans un même plan. Les transistors MOS qui permettent la collecte du courant électrique des photodiodes sont situés entre les photodiodes. Une telle architecture est chère car la surface occupée dans le silicium est la somme des surfaces des photodiodes et des transistors MOS. Elle est peu performante car toute la lumière ne parvient pas sur les photodiodes et une partie est perdue entre les photodiodes. La lumière éclairant les photodiodes est susceptible de diffuser et de perturber le fonctionnement des transistors MOS adjacents aux photodiodes.

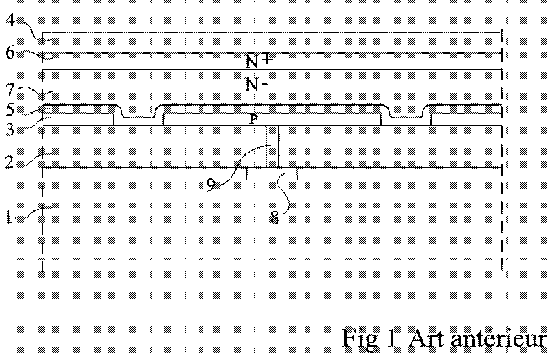

Une autre solution consiste à réaliser les photodiodes au-dessus du circuit intégré comportant les transistors MOS. Une telle structure est décrite dans la demande de brevet US 2004/0135209. La figure 1 représente une structure correspondant à cette demande US. Un circuit intégré est réalisé dans un substrat 1. Une couche isolante 2 comportant des interconnexions métalliques est réalisée au-dessus du circuit intégré. Au-dessus de la couche isolante sont formées les photodiodes. Les photodiodes comportent une électrode inférieure 3 en nitrure de titane (TiN) et une électrode supérieure 4 transparente à la lumière en oxyde d'indium et d'étain (ITO). L'électrode inférieure est en contact électrique avec une couche de silicium amorphe 5 située au-dessus et dopée de type P. L'électrode supérieure est en contact électrique avec une couche 6 sous-jacente en silicium amorphe dopé de type N. Ces deux couches de silicium amorphe dopées P et N sont séparées par une couche de silicium amorphe faiblement dopée de type N. Ainsi la structure de la figure 1 est constituée d'une photodiode verticale en silicium amorphe de type PN dont l'électrode inférieure est reliée à une région 8 du circuit intégré par un via 9 en matériau conducteur.

Dans ce type d'architecture, la place perdue entre les photodiodes est minimale, ce qui permet de collecter un maximum de signal lumineux pour un minimum de surface occupée. Il est possible, en outre d'utiliser toute la surface du silicium sous-jacent pour réaliser des fonctions électroniques complexes comme par exemple le stockage et le traitement de l'image. La photodiode, réalisée en silicium amorphe, présente une réponse chromatique sensiblement équivalente à celle de l'oeil humain. Ceci n'est pas le cas pour les photodiodes réalisées dans du silicium monocristallin qui sont particulièrement sensibles aux longueurs d'onde de l'infrarouge. Cette réponse chromatique permet de simplifier l'agencement des filtres de couleur dans le cas où on veut former une matrice de photodiodes capable de restituer une image en couleur.

Cependant, à ce jour, ces architectures conduisent à des performances réduites pour le capteur de lumière particulièrement pour les faibles éclairements. Pour collecter le courant généré par la photodiode, il faut polariser en inverse la jonction de la photodiode. Le signal lumineux crée des porteurs à proximité de la jonction PN de la photodiode. Ces porteurs sont collectés dans la zone de charge d'espace de la jonction polarisée en inverse et forment alors un photocourant qui est traité par le circuit intégré sous-jacent. La polarisation inverse de la jonction génère aussi un courant de fuite, appelé courant d'obscurité, qui est un courant parasite. Dans le cas de la photodiode de la figure 1, ce courant d'obscurité est supérieur de plusieurs décades à celui obtenu dans le cas d'une photodiode réalisée dans du silicium monocristallin. Dans ces conditions, le courant généré par la lumière pour les faibles éclairements est du même ordre de grandeur que le courant d'obscurité. La sensibilité du capteur pour les faibles niveaux d'éclairement est réduite. Cela nécessite, dans le cas de la demande de brevet US20040135209 A1 de mettre en place des moyens spécifiques pour compenser ce courant d'obscurité ("dark référence average circuit", figure 8 de la demande US).

Un objet de la présente invention est de prévoir un capteur de lumière intégrable au-dessus d'un circuit intégré et présentant des qualités électriques optimales, c'est-à-dire à la fois une réponse chromatique sensiblement similaire à celle de l'oeil humain et un courant d'obscurité minimum.

Un autre objet de la présente invention est de prévoir un tel capteur de lumière réalisable avec le minimum d'étapes technologiques.

Un autre objet de la présente invention est de prévoir un tel capteur de lumière présentant une forte densité de photodiodes de taille minimale et comportant des filtres colorés aisément réalisables.

Pour atteindre ces objets, la présente invention prévoit un capteur de lumière situé au-dessus d'un circuit intégré comportant une électrode inférieure, une couche de silicium amorphe fortement dopé d'un premier type de conductivité, et une couche de silicium amorphe faiblement dopé d'un second type de conductivité. La couche de silicium amorphe faiblement dopée repose sur une surface plane au moins au-dessus et au voisinage de l'électrode inférieure.

Selon un mode de réalisation de la présente invention, le capteur de lumière comporte une électrode inférieure en chrome en contact électrique avec le silicium amorphe faiblement dopé.

Selon un mode de réalisation de la présente invention, le capteur de lumière comporte une électrode supérieure en ITO en contact électrique avec du silicium amorphe fortement dopé.

Selon un mode de réalisation de la présente invention, les interfaces entre les électrodes et les couches de silicium amorphe sont planes.

Selon un mode de réalisation de la présente invention, l'électrode inférieure est en contact avec du silicium amorphe fortement dopé de type P.

Selon un mode de réalisation de la présente invention, l'électrode supérieure est en contact électrique avec une couche de silicium amorphe fortement dopé de type N.

L'invention vise aussi un capteur d'image constitué de photodiodes telles que susmentionnées.

Selon un mode de réalisation de la présente invention, le pas de répétition des photodiodes est inférieur à 1,5 µm.

L'invention vise aussi un objet communiquant comprenant un capteur d'image tel que susmentionné.

L'invention vise aussi un procédé de réalisation d'un capteur de lumière situé au-dessus d'un circuit intégré comportant les étapes consistant à réaliser un circuit intégré comportant à sa surface supérieure un premier composé isolant ; déposer une seconde couche isolante ; créer des cavités dans l'épaisseur de la seconde couche isolante ; déposer un métal, rendre la surface plane afin de laisser le métal uniquement dans la cavité et afin d'obtenir une surface plane au-dessus et à proximité de la cavité ; déposer une couche de silicium amorphe ; déposer une couche de silicium dopé ; et déposer une couche d'électrode.

Ces objets, caractéristiques et avantages, ainsi que d'autres de la présente invention seront exposés en détail dans la description suivante de modes de réalisation particuliers faite à titre non limitatif en relation avec les figures jointes parmi lesquelles :
La figure 1 représente un capteur de lumière intégré au-dessus d'un circuit intégré selon l'art antérieur ;
la figure 2 représente un capteur de lumière intégré au-dessus d'un circuit intégré ;
la figure 3 représente un capteur de lumière intégré au-dessus d'un circuit intégré selon un mode de réalisation de la présente invention ;
la figure 4 représente un capteur d'images réalisé au-dessus d'un circuit intégré selon la présente invention ; et
la figure 5 représente un capteur de lumière intégré au-dessus d'un circuit intégré selon un autre mode de réalisation de la présente invention.

Comme cela est usuel en matière de représentation de circuits intégrés, les échelles ne sont pas respectées dans les diverses vues en coupe afin de mettre en évidence les différentes couches et éléments des dispositifs.

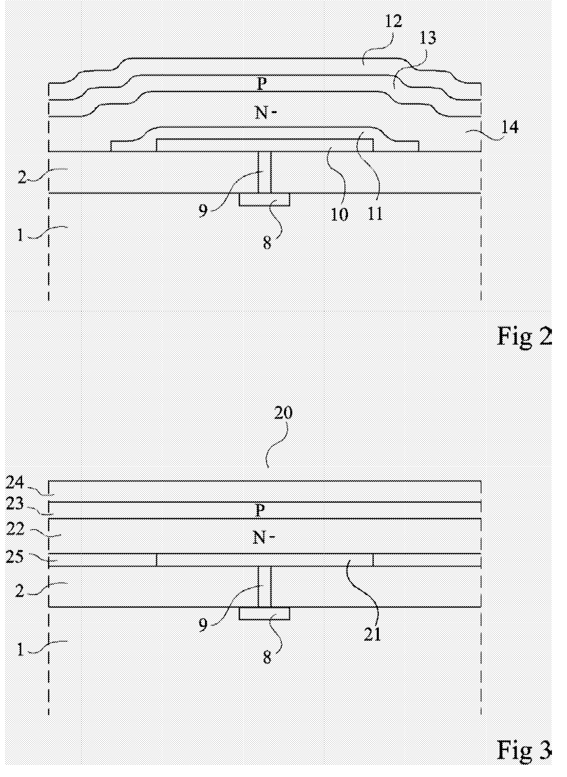

Dans une tentative pour simplifier la structure de l'art antérieur illustrée par la figure 1, la demanderesse a réalisé la structure représentée par la figure 2. Cette figure 2 décrit un circuit intégré réalisé dans un substrat 1. Une couche isolante 2, comportant des interconnexions métalliques, est réalisée au-dessus du circuit. Au-dessus de la couche isolante 2 sont formées les photodiodes. Les photodiodes comportent une électrode inférieure 10 composée d'une couche de nitrure de titane (TiN) entièrement recouverte d'une couche de chrome 11 et une électrode supérieure 12 en oxyde d'indium et d'étain (ITO). L'électrode supérieure est en contact électrique avec une couche 13 sous-jacente en silicium amorphe dopé de type P. Entre l'électrode 11 et la couche en silicium amorphe dopée P, on a réalisé une couche de silicium amorphe 14 faiblement dopée de type N. Ainsi la structure de la figure 2 susceptible de capter un signal lumineux est constituée d'une photodiode verticale en silicium amorphe de type NP. Le contact sur la zone N est un contact Schottky assuré par le chrome. La première électrode inférieure est reliée à une région 8 du circuit intégré par un via 9 en matériau conducteur.

Le fonctionnement de cette photodiode est similaire à celui de la photodiode de l'art antérieur. On s'aperçoit que, malgré les changements dans la structure des photodiodes, le courant d'obscurité est toujours important et même supérieur à celui mesuré dans l'art antérieur.

La figure 3 propose, selon un mode de réalisation de l'invention, une nouvelle structure de photodiode au-dessus d'un circuit intégré réalisé dans un substrat 1. Une couche 2 isolante, comportant les interconnexions métalliques, est réalisée au-dessus du circuit intégré. Au-dessus de la couche isolante 2 est formée une photodiode 20 qui constitue le capteur de lumière. Cette photodiode comporte successivement, de bas en haut, une électrode inférieure 21, une première zone en silicium amorphe faiblement dopé de type N 22, une deuxième zone en silicium amorphe dopé de type P et une électrode supérieure 24. L'électrode inférieure 21 est entourée d'une couche d'isolant 25 de même épaisseur. La largeur de l'électrode inférieure 21 est inférieure à 3 µm, et de préférence de l'ordre de 1,5 µm. Vue de dessus, cette électrode inférieure 21 a une forme carrée mais toute autre forme est réalisable.

L'électrode inférieure 21 est réalisée de préférence en chrome qui présente une hauteur de barrière vis-à-vis du silicium amorphe 22 apte à assurer un contact électrique avec le silicium amorphe faiblement dopé de type N. L'homme du métier sait qu'un contact électrique peut également être réalisé, par exemple, avec un métal et une couche intermédiaire de silicium fortement dopé de type N. Dans un tel cas, le procédé de réalisation est plus complexe, mais on évite l'emploi du chrome qui peut présenter une faible adhérence sur l'oxyde. Dans la réalisation présentée, ce problème d'adhérence du chrome est résolu par la diminution des dimensions de l'électrode inférieure et par le fait que l'électrode inférieure est enchâssée dans une couche d'isolant. L'électrode inférieure 21 est reliée électriquement à une région 8 du circuit intégré par un via 9 en matériau conducteur.

La première couche de silicium amorphe 22 n'est pas dopée en cours de dépôt. Cependant il existe un dopage naturel de type N. Ce silicium amorphe déposé à basse température (inférieure à 200 °C) ne présente pas de grains de taille mesurable.

La deuxième couche de silicium amorphe 23 est dopée de type P.

L'électrode supérieure 24 en ITO est reliée au circuit intégré par une connexion métallique non représentée.

La photodiode 20 de la figure 3 comporte une jonction NP entre le premier silicium amorphe 22 et le second silicium amorphe 23. Cette jonction est polarisée en inverse par le circuit intégré sous-jacent. Lorsque la photodiode est éclairée, des porteurs sont générés dans le silicium amorphe peu dopé 22 et sont ensuite collectés par la zone de charge d'espace de la jonction NP. Il en résulte un photocourant dirigé vers le circuit intégré par le via conducteur 9.

Les structures des figures 2 et 3 sont similaires. Le courant d'obscurité mesuré sur la diode de la figure 2 est de l'ordre de 100 pA/cm² pour une tension inverse de 2 volts. Par contre, le courant d'obscurité mesuré sur la diode de la figure 3 est de l'ordre de 10 pA/cm² pour une tension inverse de 2 V. Cette valeur est 10 fois plus faible que la précédente ; les performances de la photodiode sont donc fortement améliorées.

Il n'y a pas d'explication simple à cette forte diminution du courant d'obscurité. Les inventeurs considèrent toutefois que le fort courant d'obscurité de l'art antérieur est lié à la présence de dénivellations dans la couche de silicium amorphe. Le dispositif de la figure 3 est plan et le silicium amorphe dans la région 26, au droit du bord de l'électrode 21 est déposé et repose sans contraintes sur une surface plane. Ceci n'est pas le cas pour les dispositifs des figures 1 et 2 dans lesquels le silicium amorphe au droit des bords des électrodes 3 ou 10 et 11 est déposé sur une surface présentant des marches dues aux gravures des électrodes. Le silicium amorphe n'est pas très stable et sa structure cristalline évolue selon le relief sur lequel il repose. Des grains ou "clusters" de silicium, dont la taille est comprise entre 8 et 20 nm peuvent se former localement soit au cours du dépôt du silicium amorphe soit après ce dépôt. Les résultats électriques indiquent que ces clusters induisent un courant d'obscurité supplémentaire. Dans les cas des figures 1 et 2, le courant d'obscurité trouverait alors sa source à la périphérie des photodiodes.

La présente invention propose que le silicium amorphe repose sur une surface plane sur toute sa surface utile et au moins à la périphérie immédiate de cette surface utile. Une surface obtenue par un polissage mécano-chimique est considérée comme plane dans le cadre de la présente invention. Une couche déposée sur une surface présentant des marches supérieures à 20 nm est considérée comme non plane dans le cadre de la présente invention.

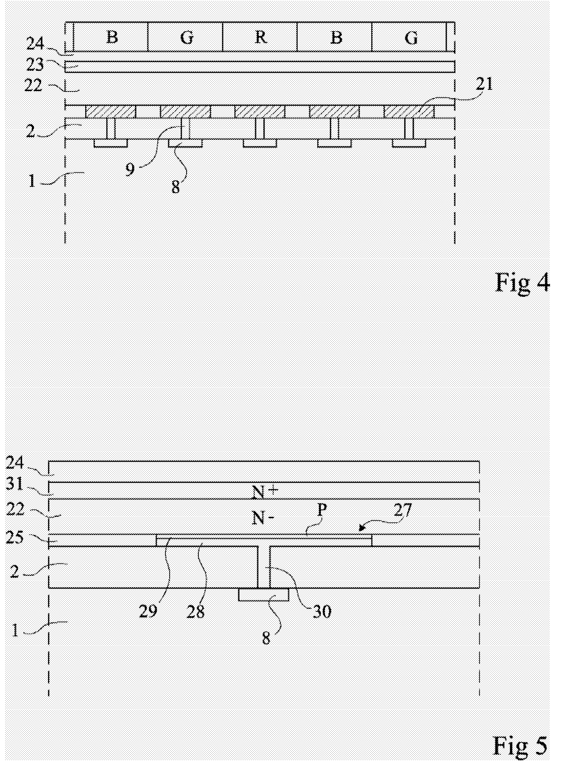

La figure 4 représente, selon l'invention, un capteur d'image réalisé au-dessus d'un circuit intégré et obtenu à partir des photodiodes représentées par la figure 3. Ce capteur est constitué de plusieurs millions de photodiodes qui comportent une pluralité d'électrodes inférieures 21 reliées au circuit intégré par des vias conducteurs 9. Une couche de silicium amorphe 22 repose sur une surface plane s'étendant sur toute la zone occupée par les électrodes inférieures. La structure du capteur d'image est complétée par une couche 24 constituée de silicium amorphe dopé P et par une couche d'ITO 25. Afin d'obtenir une image en couleur des portions de filtres colorés en bleu B, vert G, rouge R, sont déposées et gravées au-dessus de chaque électrode inférieure.

On a vu ci-dessus que, de l'avis des inventeurs, le courant d'obscurité est généré par la périphérie des photodiodes. Selon l'invention, on a supprimé cette contribution au courant d'obscurité. Il est alors possible de diminuer fortement la surface de chaque photodiode tout en gardant un rapport élevé entre le photocourant et le courant d'obscurité. L'électrode inférieure étant enchâssée dans de l'isolant, il n'est plus utile d'utiliser une couche d'accrochage comme le nitrure de titane représenté à la figure 2. La distance à respecter pour le recouvrement du nitrure de titane par le chrome devient sans objet. La structure proposée par la figure 4 est particulièrement dense. Le pas de répétition des électrodes inférieures peut atteindre 1,5 µm. On peut obtenir une forte densité de capteurs avec une très bonne qualité.

Cependant il faut également réaliser les filtres colorés B, G, R selon le pas des capteurs. Ces filtres sont réalisés à partir de photorésines négatives qui, une fois insolées, restent sur le capteur d'image. Ces résines sont particulièrement sensibles aux réflexions parasites de la lumière sur les flancs présentés par les couches sous-jacentes. En d'autres termes, pour obtenir une bonne définition pour ces résines négatives, il est nécessaire d'avoir des surfaces sous-jacentes parfaitement planes. Ceci est réalisé selon l'invention sans utiliser de couche intermédiaire apte à rendre plane la surface.

Le circuit intégré sous-jacent au capteur d'images peut faire partie intégrante d'un objet communiquant tel qu'un appareil photo numérique, un fax, un téléphone portable ou un ordinateur portable. Le circuit intégré peut également participer activement au fonctionnement de l'objet communiquant dans lequel il est inséré.

Un mode de réalisation des photodiodes selon les figures 3 ou 4 est le suivant, les valeurs numériques étant indiquées uniquement à titre d'exemple :
- réaliser un circuit intégré comportant une couche supérieure isolante de type TiN, par exemple ;
- déposer une couche d'oxyde TEOS de 200 à 500 nm d'épaisseur ;
- creuser une cavité destinée à recevoir l'électrode inférieure ;
- sensiblement au centre de cette cavité creuser un via jusqu'à une couche conductrice interne du circuit intégré ;
- déposer une couche de chrome d'épaisseur comprise entre 300 et 800 nm de façon à remplir la cavité et le via ;
- réaliser une étape de CMP afin de dégager la surface supérieure de l'oxyde TEOS et de laisser le chrome uniquement dans les cavités et les vias ;
- déposer une couche de silicium amorphe non dopée d'épaisseur comprise entre 0,35 et 1,3 µm, et de préférence d'épaisseur égale à 0,45 µm, le dopage naturel de cette couche étant de type N et de préférence inférieur à 5.10¹⁴ at/cm³ ;
- déposer une couche de silicium amorphe dopé de type P d'épaisseur comprise entre 10 et 30 nm avec une concentration de bore supérieure à 10¹⁸ at/cm³, le dopant pouvant être apporté en cours de dépôt par du triméthylborane (TMB) ;
- déposer par PVD une couche d'ITO d'une épaisseur d'environ 80 nm ;
- déposer une résine photosensible de type négative verte d'une épaisseur d'environ 1 µm, et la graver ; et
- déposer des résines photosensibles rouge et bleue dans les même conditions que ci-dessus, et les graver.

L'invention est susceptible de nombreuses variantes aisément accessibles à l'homme du métier. En particulier le métal de l'électrode inférieure peut être différent, des couches intermédiaires de silicium amorphe peuvent être ajoutées, les dopages des couches de silicium amorphe peuvent être modifiés.

La figure 5 illustre un autre mode de réalisation de la présente invention. Un circuit intégré est réalisé dans un substrat 1 et comporte des zones diffusées conductrices 8. Les interconnexions de ce circuit intégré sont réalisées dans divers couches d'isolant 2 déposées au-dessus du circuit intégré. Une couche isolante 25 repose au-dessus de la couche isolante 2. Des cavités 27 dans cette couche 25 contiennent successivement un matériau très conducteur 28 et du silicium amorphe 29 fortement dopé de type P. Le matériau conducteur 28 peut être un métal, du nitrure de titane ou tout autre matériau conducteur. Il est de préférence directement en contact électrique avec la zone conductrice 8 du circuit intégré par l'intermédiaire d'un via 30. La surface au-dessus de la couche 25 est plane. Les cavités sont remplies de façon que la surface supérieure de la couche 29 soit sensiblement au même niveau que la surface de l'isolant 25. Une couche de silicium amorphe peu dopée 22 de type N repose sur cette surface plane. La structure de la photodiode est alors achevée par une couche 31 de silicium amorphe fortement dopée de type N et par une électrode supérieure en ITO.

La photodiode est constituée par la jonction des matériaux en silicium amorphe de type P 29 et de type N 22. La couche de silicium amorphe 31 fortement dopée de type N est utilisée pour obtenir un contact ohmique de l'électrode supérieure 24 avec le silicium amorphe faiblement dopé 22.

Cette structure se distingue de celle de l'art antérieur représenté par la figure 1 par la planéité des différentes couches de silicium amorphe. Le courant d'obscurité de la structure de la figure 5 est minimum car selon l'invention le silicium amorphe 22 est déposé sur une surface plane. Un autre avantage vis-à-vis de l'art antérieur est une meilleure densité et une meilleure isolation du silicium amorphe de type P 29 enchâssé dans un isolant.

## Revendications

1. Capteur de lumière situé au-dessus d'un circuit intégré dont la surface supérieure est couverte d'une couche isolante plane (2), comportant une électrode inférieure (21 ; 28, 29), et une couche de silicium amorphe faiblement dopé (22) qui déborde par rapport à l'électrode, **caractérisé en ce que** l'électrode inférieure est entourée d'une couche isolante (25) de même épaisseur que ladite électrode.

2. Capteur de lumière selon la revendication 1, dans lequel l'électrode inférieure (21) est en chrome et est en contact électrique avec le silicium amorphe faiblement dopé.

3. Capteur de lumière selon la revendication 2, ayant une électrode supérieure en ITO (24) en contact électrique avec du silicium amorphe (23) fortement dopé du type de conductivité opposé à celui de la couche de silicium amorphe faiblement dopé.

4. Capteur de lumière selon la revendication 1, dans lequel l'électrode inférieure comprend une portion de couche conductrice (28) recouverte d'une couche de silicium amorphe fortement dopé (29) du type de conductivité opposé à celui de ladite couche de silicium amorphe faiblement dopé.

5. Capteur de lumière selon la revendication 5, comprenant en outre une couche (31) de silicium amorphe supérieure fortement dopé du même type que la couche de silicium amorphe faiblement dopé, recouverte d'une électrode supérieure (24) .

6. Capteur d'image constitué de photodiodes selon l'une quelconque des revendications 1 à 5.

7. Capteur d'image selon la revendication 6, comportant des filtres colorés directement en contact avec l'électrode supérieure.

8. Capteur d'image selon la revendication 6, dans lequel le pas de répétition des photodiodes est inférieur à 1,5 µm.

9. Objet communiquant comprenant un capteur d'image selon l'une quelconque des revendications 6 à 8.

10. Procédé de réalisation d'un capteur de lumière situé au-dessus d'un circuit intégré comportant les étapes suivantes :
réaliser un circuit intégré (1) comportant à sa surface supérieure un premier composé isolant (2) ;
déposer une seconde couche isolante (25) ;
créer des cavités dans l'épaisseur de la seconde couche isolante ;
déposer un métal, rendre la surface plane afin de laisser le métal uniquement dans la cavité et afin d'obtenir une surface plane au-dessus et à proximité de la cavité ;
déposer une couche de silicium amorphe (22) ;
déposer une couche de silicium dopé (23) ; et
déposer une couche d'électrode (24).
